Europäisches Patentamt

European Patent Office

Office européen des brevets

(19)

(11) Veröffentlichungsnummer: **0 217 358 B1**

(12) **EUROPÄISCHE PATENTSCHRIFT**

(45) Veröffentlichungstag der Patentschrift: **22.04.92**

(51) Int. Cl.5: **G11C 8/00**

(21) Anmeldenummer: **86113435.1**

(22) Anmeldetag: **30.09.86**

(54) **Verfahren und Schaltungsanordnung zum inhaltsgesteuerten Adressieren eines Speichers.**

(30) Priorität: **02.10.85 DE 3535215**

(43) Veröffentlichungstag der Anmeldung:
**08.04.87 Patentblatt 87/15**

(45) Bekanntmachung des Hinweises auf die
Patenterteilung:
**22.04.92 Patentblatt 92/17**

(84) Benannte Vertragsstaaten:
**CH DE FR GB IT LI NL SE**

(56) Entgegenhaltungen:
**EP-A- 0 155 370**
**EP-A- 0 155 731**

**PATENT ABSTRACTS OF JAPAN, Band 8, Nr.
237 (P-310)[1674], 30. Oktober 1984; & JP-
A-59 112 338 (FUJITSU K.K.) 28-06-1984**

**PATENT ABSTRACTS OF JAPAN, Band 7, Nr.
54 (P-180)[1199], 4. März 1983; & JP-A-57 200
984 (FUJITSU K.K.) 09-12-1982**

**PATENT ABSTRACTS OF JAPAN, Band 8, Nr.
60 (P-262)[1497], 22. März 1984; & JP-A-58 208
981 (NIPPON DENKI K.K.) 05-12-1983**

**PATENT ABSTRACTS OF JAPAN, Band 7, Nr.**

**253 (P-235)[1398], 10. November 1983; & JP-
A-58 137 180 (SONY K.K.) 15-08-1983**

(73) Patentinhaber: **Siemens Nixdorf Informationssysteme Aktiengesellschaft
Fürstenallee 7
W-4790 Paderborn(DE)**

(72) Erfinder: **Berndt, Siegward
Winkelfeld 16
W-4793 Büren-Ahden(DE)**

(74) Vertreter: **Fuchs, Franz-Josef, Dr.-Ing. et al
Postfach 22 16 34
W-8000 München 22(DE)**

EP 0 217 358 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services

## Beschreibung

Die Erfindung betrifft ein Verfahren nach dem Oberbegriff des Patentanspruchs 1 und eine Schaltungsanordnung zur Durchführung des Verfahrens.

Durch die US-PS 4 523 301 ist es bekannt, die Adreßwerte zum inhaltsgesteuerten Adressieren eines Assoziativspeichers mit einem Zähler zu erzeugen, der sämtliche möglichen Adreßwerte des gesamten Speichervolumens durch Abzählen an seinen Zählausgängen bereitstellt. Ein solches Prinzip eignet sich auch dazu, auf adressengesteuerten Zugriff umzuschalten, weil es keinen besonderen, dem Assoziativbetrieb angepaßten Speicheraufbau benötigt. Es ist jedoch unter vertretbarem Zeitaufwand nur auf relativ kleine Speicher anwendbar. Bekannte Assoziativspeicher, deren gesamtes Speichervolumen in einem Abfragezyklus zu adressieren ist, werden daher auch entsprechend klein gehalten.

Aus EP-A-0 155 173 ist es bekannt, einen Speicher mittels taktgesteuerter und in vorbestimmten Adreßabständen fortlaufend erzeugter Adreßwerte zu adressieren, wobei die Adreßwerte ausgehend von einem frei wählbaren Anfangsadreßwert durch Addieren eines frei wählbaren Summanden zum jeweils aktuellen Adreßwert erzeugt werden.

Soll aber ein großer Speicher, z.B. der Hauptspeicher einer Datenverarbeitungsanlage, inhaltsgesteuert abgefragt werden, so ist das vorstehend genannte bekannte Verfahren zwar grundsätzlich anwendbar, jedoch nicht wirtschaftlich.

Die Aufgabe der Erfindung besteht darin, ein Verfahren und eine Schaltungsanordnung zum inhaltsgesteuerten Adressieren eines Speichers anzugeben und dabei den wirtschaftlichen Einsatz auch bei großen Speichern zu ermöglichen.

Die Erfindung löst diese Aufgabe durch die Merkmale des Patentanspruchs 1 bzw. des Patentanspruchs 5. Vorteilhafte Weiterbildungen sind Gegenstand der Unteransprüche 2 bis 4 bzw. 6 bis 8.

Durch die Erfindung ist es gleichfalls möglich, den inhaltsgesteuerten Speicherzugriff auch bei einem Speicher einer Datenverarbeitungsanlage durchzuführen, auf den hauptsächlich adressengesteuert zugegriffen wird, denn ohne zusätzlichen Speicheraufwand für assoziative Adreßwerte und ohne Zeitaufwand für das Laden zusätzlicher Speicher wird lediglich ein Additionsvorgang zur Erzeugung jeweils eines assoziativen Adreßwertes durchgeführt. Darüber hinaus ist es aber auch möglich, diese Art der Adreßwerterzeugung nur für einen Teil des Volumens eines relativ großen Speichers durchzuführen, indem der Anfangsadreßwert entsprechend gewählt wird. In vielen Fällen ist nämlich insbesondere bei Großspeichern der inhaltsgesteuerte Zugriff nur in einem bestimmten Speicherbereich durchzuführen. Ein ähnlicher Effekt der Verringerung des Zeitaufwandes für das inhaltsgesteuerte Adressieren ergibt sich durch die Verwendung eines frei wählbaren, einen vorbestimmten Abstand zwischen jeweils zwei aufeinander folgenden Adreßwerten angebenden Summanden. Es kann nämlich eine Art des inhaltsgesteuerten Speicherzugriffs gewünscht sein, bei der die Adreßwerte nicht alle, sondern nur regelmäßig beabstandete Speicherplätze eines Speichers ansteuern sollen. Der zur Adreßwerterzeugung verwendete Summand kann dann so gewählt werden, daß die Adreßwerte als Ergebnisse der fortlaufend durchgeführten Addition nicht mit dem Abstand einer Adreßwerteinheit, sondern mit einem größeren Abstand aufeinander folgen.

Eine gleichzeitige Anwendung der Begrenzung des inhaltsgesteuert abgefragten Adreßvolumens und der Vergrößerung der Abfrageschritte führt natürlich zu einer entsprechend grossen Zeiteinsparung insbesondere bei Großspeichern.

Die Erfindung wird im folgenden an Hand der Zeichnung näher erläutert. Darin zeigen:

Fig. 1    eine schematische Übersicht der wesentlichen Teile einer Datenverarbeitungsanlage gemäß einem Ausführungsbeispiel, auf deren Speicher wahlweise adressengesteuert oder inhaltsgesteuert zugegriffen werden kann,

Fig. 2    einen in dem in Fig. 1 gezeigten System verwendeten Adressierer und

Fig. 3    den Aufbau und die Arbeitsweise des in Fig. 2 gezeigten Adressierers.

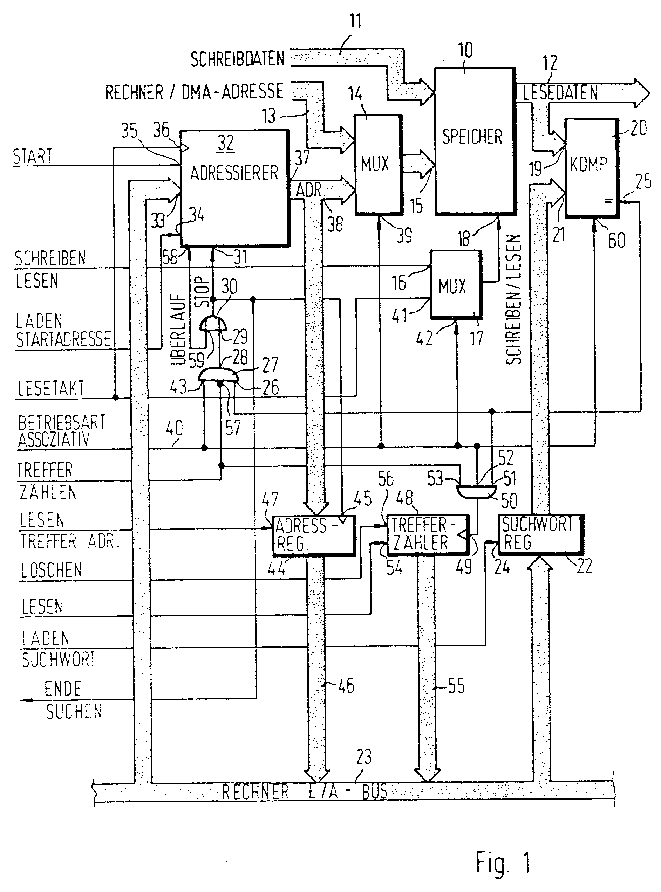

Die in Fig. 1 gezeigte Schaltungsanordnung hat als wesentlichen Bestandteil einen Speicher 10, der zugleich der Hauptspeicher der Datenverarbeitungsanlage ist und in den über einen Datenweg 11 von dem nicht dargestellten Rechner oder einer Speicherdirektzugriffs-Schaltung (DMA- Direct memory access) Daten eingeschrieben werden können. Über einen zweiten Datenweg 12 können aus dem Speicher 10 Daten ausgelesen werden. Dieses Einschreiben und Auslesen erfolgt mit Adressen, die über einen Adreßweg 13 zugeführt werden können und durch einen ersten Multiplexer 14 im Normalbetrieb auf die Adreßeingänge 15 des Speichers 10 geschaltet werden.

Der Schreib- bzw. Lesebetrieb des Speichers 10 wird gesteuert durch ein Schreib-Lesesignal, welches der Schaltungsanordnung über einen Eingang 16 von dem dem Speicher 10 zugeordneten Rechner bzw. der DMA im Rahmen des Normalbetriebs zugeführt wird. Das Schreib-Lesesignal gelangt über einen zweiten Multiplexer 17 an den Schrieb-Lese-Steuereingang 18 des Speichers 10.

Der zweite Datenweg 12 für die aus dem Speicher 10 gelesenen Daten ist mit den ersten Eingängen 19 eines Komparators 20 verbunden. Die zweiten Eingänge 21 des Komparators 20 sind mit eins Suchwortregister 22 verbunden, in das über den E/A-Bus 23 des Rechners von letzterem ein Suchwort eingegeben werden kann. Die Übernahme des Suchwortes in das Suchwortregister 22 erfolgt mit einem Steuerbefehl "Laden Suchwort", das der Schaltungsanordnung über den entsprechenden Steuereingang 24 zugeführt wird. Der Komparator 20 arbeitet derart, daß bei Übereinstimmung eines Suchwortes, welches ihm von dem Register 22 über die Eingänge 21 zugeführt wird, mit einem aus dem Speicher 10 gelesenen Datenwort, welches ihm über die Eingänge 19 zugeführt wird, an seinem Ausgang 25 ein Treffersignal abgegeben wird. Dieses Treffersignal wird dem ersten Eingang 26 eines konjunktiven Verknüpfungsgliedes 27 zugeführt, dessen Ausgang 28 mit einem Eingang 29 eines disjunktiven Verknüpfungsgliedes 30 verbunden ist. Der Ausgang dieses Verknüpfungsgliedes 30 führt auf den Stopeingang 31 eines Adressierers 32.

Allgemein gilt, daß der Adressierer, ausgehend von einem Anfangsadresswert, eine Anzahl von direkt oder in größeren Schritten aufeinanderfolgenden Speicheradressen erzeugt. Die Anfangs- oder auch Startadresse wird über Ladeeingänge 33 vom E/A-Bus 23 in den Adressierer 32 geladen. Die Übernahme der Startadresse in den Adressierer 32 erfolgt mit einem Steuerbefehl "Laden Startadr.", der dem Adressierer 32 über den entsprechenden Steuereingang 34 zugeführt wird. Der Adressierer 32 wird durch ein Startsignal des Rechners an seinem Startsignaleingang 35 gestartet.

Die Adressenfortschaltfunktion des Adressierers 32 wird durch ein Lesetaktsignal gesteuert, welches ihm an einem Takteingang 36 zugeführt wird. Die Adressenausgänge 37 des Adressierers 32 sind über einen weiteren Adressweg 38 mit dem Multiplexer 14 verbunden. Wenn dieser an seinem Umshaltsignaleingang 39 durch ein Betriebsartensignal 40 auf Assoziativbetrieb des Speichers 10 umgeschaltet wird, so werden die Ausgangssignale des Adressierers 32 als Adressen dem Speicher 10 über dessen Adresseingänge 15 zugeführt. Das Lesetaktsignal ist ferner auf den zweiten Eingang 41 des zweiten Multiplexers 17 geführt, dessen Umschaltsignaleingang 42 ebenfalls mit dem Betriebsartensignal 40 derart beaufschlagt ist, daß im Assoziativbetrieb des Speichers 10 dieser von dem Lesetakt getaktet wird.

Das Betriebsartensignal 40 ist ferner auf den zweiten Eingang 43 des konjunktiven Verknüpfungsgliedes 27 geführt und steuert dieses derart, daß im Normalbetrieb am Ausgang des disjunktiven Verknüpfungsgliedes 30 ein permanentes Stopsignal ansteht.

Schließlich ist das Betriebsartensignal 40 noch auf den Enable-Eingang 60 des Komparators 20 gelegt und beaufschlagt diesen derart, daß an seinem Ausgang 25 nur im Assoziativbetrieb ein Treffersignal entstehen kann.

Die Adressenausgänge 37 des Adressierers 32 können ferner über den zweiten Adressweg 38 einem Adressregister 44 zugeführt werden, welches an seinem Ladesteuereingang 45 durch das am Ausgang des disjunktiven Verknüpfungsgliedes 30 entstehende Stopsignal gesteuert wird. Diese Steuerung erfolgt derart, daß die Information an den Adressausgängen 37 des Adressierers 32 in das Adressregister 44 übernommen wird, sobald der Adressierer 32 gestoppt wird.

Der Inhalt des Adressregisters 44 kann über einen Datenweg 46 auf den E/A-Bus des Rechners geschaltet werden, wenn letzterer ein Befehlssignal "Lesen Trefferadresse" auf den Lesesteuereingang 47 des Adressregisters 44 schaltet.

Die in Fig. 1 dargestellte Schaltungsanordnung enthält einen Trefferzähler 48, der an einem Zähleingang 49 durch das Ausgangssignal eines zweiten konjunktiven Verknüpfungsgliedes 50 angesteuert wird. Der erste Eingang 51 dieses Verknüpfungsgliedes ist mit dem Treffersignal, also dem Signal am Ausgang 25 des Komparators 20, beaufschlagt. Der zweite Eingang 52 des Verknüpfungsgliedes 50 ist mit dem Betriebsartsignal 40 beschaltet, der dritte Eingang 53 kann vom Rechner mit einem Steuersignal "Treffer Zählen" angesteuert werden. Am Ausgang des Verknüpfungsgliedes 50 entsteht dann ein Zählimpuls, wenn der Komparatorausgang 25 einen Treffer, also eine Übereinstimmung zwischen Speicher- und Suchwortregister-Inhalt meldet, die Betriebsart "Assoziativ" eingestellt ist und der Rechner den Befehl "Treffer Zählen" gegeben hat. Der Inhalt des Trefferzählers 48 kann mit einem Rechnerbefehl "Lesen Trefferzähler", der auf einen Leseeingang 54 des Trefferzählers 48 geschaltet wird, über einen Datenweg 55 auf den E/A-Bus 23 des Rechners geschaltet werden. Der Trefferzähler 48 verfügt über einen Löscheingang 56, über den er mit einem Rechnerbefehl "Löschen" auf Null gesetzt werden kann.

Das Steuersignal "Treffer Zählen" ist außerdem auf einen Negationseingang 57 des ersten konjunktiven Verknüpfungsgliedes 27 geführt.

Wenn der Adressierer 32 alle durch ihn erzeugbaren Adressen durchlaufen hat, so erzeugt er an einem Überlauf-Ausgang 58 ein Meldesignal, das auf den zweiten Eingang 59 des disjunktiven Verknüpfungsgliedes 30 geschaltet ist. Die logische Schaltung der Verknüpfungsglieder 27 und 30, an deren Ausgang das Stopsignal für den Adressierer 32 entsteht, genügt der folgenden logischen Gleichung:

Stop = Überlauf + (Betriebsart assoziativ $\cdot$ $\overline{\text{Treffer}}$ $\overline{\text{zählen}}$ $\cdot$ Treffer)   (1)

Wenn mit der in Fig. 1 dargestellten Schaltungsanordnung ein assoziativer Lesebetrieb durchgeführt werden soll, so wird zunächst vom Rechner das Suchwort auf dem E/A-Bus 23 bereitgestellt. Dann gibt der Rechner den Befehl "Laden Suchwort" aus, worauf das Suchwort in das Suchwortregister 22 geladen wird. Im nächsten Schritt schaltet der Rechner die Startadresse auf den E/A-Bus 23, von wo sie mit dem vom Rechner ausgegebenen Befehl "Laden Startadresse" in den Adressierer 32 geladen wird. Darauf gibt der Rechner den Befehl "Betriebsart assoziativ" aus und startet den Adressierer 32 durch Anlegen des Befehls "Start" an dessen Startsignaleingang 35.

An den Adressenausgängen 37 des Adressierers 32 steht nun die eben geladene Startadresse an, welche über den auf Assoziativbetrieb geschalteten Multiplexer 14 an den Adresseneingängen 15 des Speichers 10 anliegt. Über den ebenfalls auf Assoziativbetrieb geschalteten zweiten Multiplexer 17 wird das Lesetaktsignal auf den Schreib-Lese-Steuereingang 18 des Speichers 10 gelegt. Letzterer gibt daraufhin das mit der Startadresse bezeichnete Speicherwort über den zweiten Datenweg 12 an den Komparator 20, wo es mit dem Inhalt des Suchwortregisters 22 verglichen wird.

Während mit der Vorderflanke des Lesetaktsignals der Speicher 10 wie beschrieben ausgelesen wird, schaltet dessen Rückflanke den Adressierer 32 über seinen Takteingang 36 derart fort, daß an dessen Adressenausgängen die nächste Adresse erscheint. Das mit dieser Adresse bezeichnete Speicherwort gelangt ebenfalls an den Komparator 20, wo mit ihm in der vorbeschriebenen Weise verfahren wird. Diese Suchroutine wird so oft wiederholt, bis der Komparator 20 die Übereinstimmung zwischen Speicher- und Suchwort feststellt und über seinen Ausgang 25 "Treffer" meldet. Damit ist die logische Gleichung (1) erfüllt,und der Adressierer 32 wird über einen Stopeingang 31 angehalten.

Gleichzeitig wird die Adresse, unter der das gesuchte Wort im Speicher 10 abgespeichert ist, in das Adressregister 44 geladen.

Ist das gesuchte Wort nicht im Speicher 10 abgespeichert, so durchläuft der Adressierer 32 alle von ihm erzeugbaren Adressen, ohne gestoppt zu werden. Nach Abarbeiten der Suchroutine mit der höchstmöglichen Adresse gibt der Adressierer 32 an seinem Ausgang 58 das Überlaufsignal ab, womit die logische Gleichung (1) ebenfalls erfüllt ist, und der Adressierer 32 über seinen Stopeingang 31 angehalten wird.

Für einen anderen Betriebsfall der Datenverarbeitungsanlage kann es interessant sein festzustellen, wie oft das Suchwort im Speicher vorhanden ist. In diesem Fall gibt der Rechner noch den Befehl "Treffer zählen" aus, der an dem Eingang 53 des Verknüpfungsgliedes 50 anliegt. Läuft die Suchroutine nun wie oben beschrieben ab, so wird die für das Verknüpfungsglied 50 geltende logische Gleichung

Zählimpuls = Betriebsart assoziativ $\cdot$ Treffer zählen $\cdot$ Treffer   (2)

immer dann erfüllt, wenn der Komparator 20 eine Übereinstimmung von Such- und Speicherwort feststellt. Da die logische Gleichung (1) bei einem Treffer nicht erfüllt ist, wird der Adressierer 32 in diesem Fall erst angehalten, wenn das Überlaufsignal auftritt.

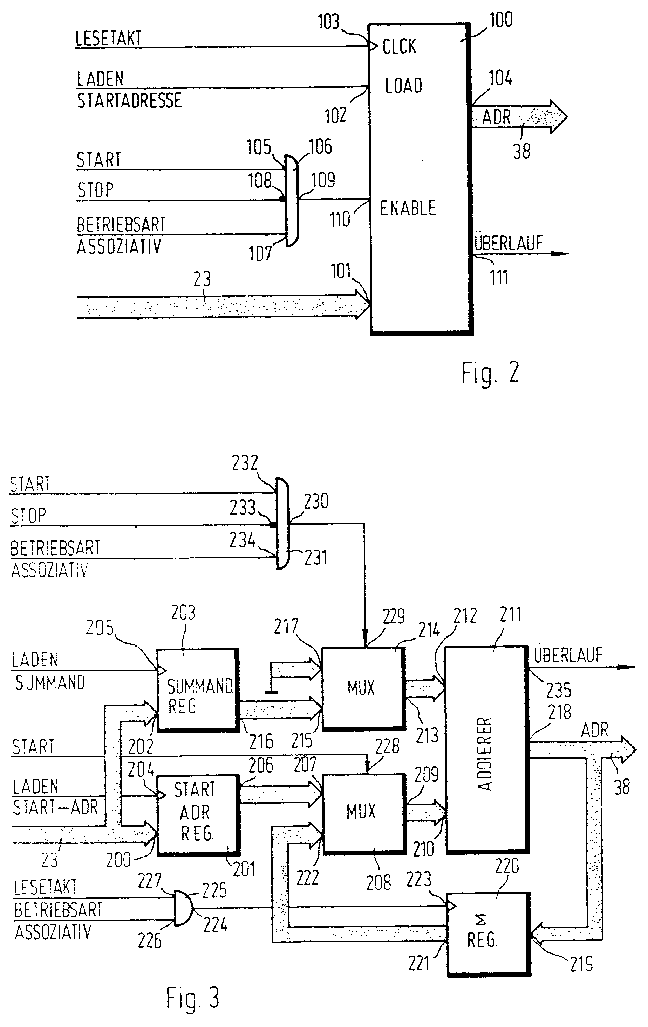

Im einfachsten Fall kann der Adressierer 32 im wesentlichen aus einem handelsüblichen programmierbaren Zähler bestehen, wie dieser in Fig. 2 gezeigt und mit 100 bezeichnet ist. Die vom E/A-Bus 23 auf die Dateneingänge 101 des Zählers 100 geführte Startadresse wird mit dem am Load-Steuereingang 102 angelegten Steuerbefehl "Laden Startadresse" in den Zähler 100 übernommen. Der Lesetakt ist auf den Zähleingang 103 geschaltet. Die Datenausgänge 104 des Zählers 100 sind mit dem zweiten Adressweg 38 verbunden.

Das Startsignal des Rechners ist auf einen ersten Eingang 105 eines konjunktiven Verknüpfungsgliedes 106 geführt, dessen zweiter Eingang 107 mit dem Steuerbefehl "Betriebsart assoziativ" und dessen Negationseingang 108 mit dem Stop-Signal beaufschlagt ist. Der Ausgang 109 des Verknüpfungsgliedes 106 ist mit dem Freigabeeingang (Count enable) 110 verbunden. Das Verknüpfungsglied 106 genügt der logischen Gleichung

Count enable = Betriebsart assoziativ $\cdot$ $\overline{\text{Stop}}$ $\cdot$ Start   (3)

Der Zähler 100 wird also in der Betriebsart assoziativ mit dem Startsignal gestartet und zählt ausgehend von der Startadresse die an seinem Zähleingang 103 auftretenden Lesetaktsignale, was gleichbedeutend ist mit einer Erhöhung des Datums an den Datenausgängen 104 jeweils um 1. Der Zählvorgang wird bis zum Auftreten eines Stop-Signals am Eingang 108 des Verknüpfungsgliedes 106 - womit die logische Gleichung (3) nicht mehr erfüllt ist - fortgesetzt. Als Überlaufsignal ist das am Ausgang 111 des Zählers 100 abgreifbare Zählerübertragssignal nutzbar.

Wie bereits erwähnt, wird bei der Schaltungsanordnung nach Fig. 2 die an den Ausgängen 104 des Zählers 100 auftretende Assoziativadresse jeweils um 1 erhöht. Oft ist es aber zweckmäßig, die Adressenfolge in größeren, frei wählbaren Schritten zu erhöhen. Mit einem Adressierer nach Fig. 3 ist dies möglich.

Der E/A-Bus 23 des Rechners ist zum einen auf die Dateneingänge 200 eines Startadressregisters 201 und zum anderen auf die Dateneingänge 202 eines Summandenregisters 203 geschaltet. Die Übernahme der Startadresse in das Startadressregister 201 erfolgt mit dem Steuerbefehl "Laden Startadresse", der dem Register 201 über dessen Ladesteuereingang 204 zugeführt wird. Die Übernahme eines mit "Summand" bezeichneten Datenwortes in das Summandenregister 203 erfolgt unter Steuerung eines vom Rechner an den Ladesteuereingang 205 des Registers 203 ausgegebenen Steuerbefehls "Laden Summand".

Die Adressenausgänge 206 des Startadressregisters 201 sind mit den ersten Eingängen 207 eines Multiplexers 208 verbunden, dessen Ausgänge 209 auf erste Summandeneingänge 210 eines Addierers 211 geführt sind. Die zweiten Summandeneingänge 212 des Addierers 211 sind mit den Ausgängen 213 eines weiteren Multiplexers 214 zusammengeschaltet, dessen erste Eingänge 215 von den Ausgängen 216 des Summandenregisters 203 versorgt werden. Die zweiten Eingänge 217 des Multiplexers 214 sind mit Null-Potential beschaltet, was gleichbedeutend mit dem Datenwort 0 ist.

Die Datenausgänge 218 des Addierers 211 sind zum einen auf den zweiten Adressweg 38 (Fig. 1) geschaltet und führen zum anderen auf die Dateneingänge 219 eines Summenregisters 220, dessen Datenausgänge 221 wiederum auf die zweiten Eingänge 222 des Multiplexers 208 geschaltet sind. Der Ladesteuereingang 223 des Summenregisters 220 ist mit dem Ausgang 224 eines konjunktiven Verknüpfungsgliedes 225 verbunden, dessen erster Eingang 226 mit dem Steuerbefehl "Betriebsart assoziativ" und dessen zweiter Eingang 227 mit dem Lesetaktsignal beaufschlagt ist. Die logische Verknüpfung dieser beiden Steuersignale erfolgt derart, daß die Daten an den Dateneingängen 219 des Summenregisters 220 mit der Rückflanke des Lesetaktsignals in das Summenregister übernommen werden, wenn das Steuersignal "Betriebsart assoziativ" aktiv ist.

Der Umschaltsignaleingang 228 des Multiplexers 208 ist derart mit dem Startsignal beaufschlagt, daß bei aktivem Startsignal die zweiten Eingänge 222 des Multiplexers 208 auf dessen Ausgänge 209 durchgeschaltet sind. Der Umschaltsignaleingang 229 des Multiplexers 214 ist mit dem Ausgang 230 eines konjunktiven Verknüpfungsgliedes 231 verbunden, dessen drei Eingänge mit den folgenden Signalen beschaltet sind.

Eingang 232:
Startsignal

invertierender Eingang 233:
Stopsignal
Eingang 234:
Betriebsart assoziativ

Die ersten Eingänge 215 des Multiplexers 214 sind dann auf dessen Ausgänge 213 geschaltet, wenn für das Verknüpfungsglied 231 und damit für den Umschaltsignaleingang 229 des Multiplexers 214 folgende logische Gleichung erfüllt ist:

$$\text{Summandenregister durchgeschaltet} = \text{Start} \cdot \text{Betriebsart Assoziativ} \cdot \overline{\text{Stop}} \qquad (4)$$

Die Arbeitsweise des Adressierers nach Fig. 3 ist folgende:
Wie bereits für Fig. 1 beschrieben, wird nach dem Laden des Suchwortes in das Suchwortregister 22 (Fig. 1) vom Rechner die Startadresse auf dem E/A-Bus 23 bereitgestellt. Mit dem Auftreten des Steuersignals "Laden Startadresse" am Ladesteuereingang 204 des Startadressregisters 201 wird die Startadresse in letzteres übernommen. Bei den früher beschriebenen Adressierern wurde als nächstes der Steuerbefehl "Betriebsart assoziativ" vom Rechner ausgegeben. Hier folgt jedoch zunächst die Bereitstellung des Summanden auf dem E/A-Bus 23. Dieses Datum wird mit dem vom Rechner auf den Ladesteuereingang 205 des Summandenregisters 203 ausgegebenen Steuerbefehl "Laden Summand" in letzteres übernommen. Nun wird vom Rechner der Steuerbefehl "Betriebsart assoziativ" ausgegeben.

Da der Startbefehl noch nicht vom Rechner ausgegeben wurde, sind die Ausgänge 206 des Startadressregisters 201 über den Multiplexer 208 mit den ersten Summandeneingängen 210 des Addierers 211 verbunden. Ferner ist die logische Gleichung (4) nicht erfüllt, wodurch das an den zweiten Eingängen 217 des Multiplexers 214 anliegende Datenwort "0" auf Jie zweiten Summandeneingänge 212 des Addierers 211 geschaltet ist. An den Ausgängen 218 des Addierers 211 und damit an den Adresseingängen 15 des Speiches 10 (Fig. 1) steht also die Startadresse an. Das im Speicher 10 mit der Startadresse bezeichnete Datenwort wird also als erstes wie beschrieben mit dem Inhalt des Suchwortregisters 22 (Fig. 1) verglichen. Mit dem nächstfolgend Lesetaktsignal wird die Startadresse auch in das Summenregister 220 übernommen.

Wird nun vom Rechner das Startsignal ausgegeben, so wird der Multiplexer 208 über seinen Umschaltsignaleingang 228 so eingestellt, daß die Ausgänge 221 des Summenregisters 220 auf die ersten Summandeneingänge 210 des Addierers 211 geschaltet werden. Mit Aktivierung des Startsignals ist auch Gleichung (4) erfüllt, womit der Multiplexer 214 die Ausgänge 216 des Summandenregisters 203 auf die zweiten Summandeneingänge

5

212 des Addierers 211 schaltet. An den Ausgängen 218 des Addierers 211 tritt nun ein Adresswort für den Speicher 10 (Fig. 1) auf, das den Wert "Startadresse + Summand" hat. Dieses wird wie beschrieben auch in das Summenregister 220 geladen. Nach dem nächsten Lesetakt hat die Adresse an den Ausgängen 218 des Addierers 211 den Wert Startadresse + 2 x Summand.

An einem Übertragsausgang 235 des Addierers 211 wird das Überlaufsignal ausgegeben, wenn der Addierer 211 die höchste durch ihn darstellbare Adresse ausgegeben hat. Das ist dann der Fall, wenn das Suchwort im Speicher 10 nicht gefunden wurde oder wenn die Schaltungsanordnung nach Fig. 1 auf die Betriebsart "Treffer zählen" eingestellt wurde.

Bei Auftreten eines Treffersignals bzw. des Überlaufsignals ist die Gleichung (1) erfüllt, und es entsteht das Stopsignal wie oben beschrieben. Jetzt ist die Gleichung (4) nicht mehr erfüllt, womit das an den zweiten Eingängen 217 des Multiplexers 214 anliegende Datenwort "0" wieder auf die zweiten Eingänge 212 des Addierers 211 geschaltet wird. Der Adresswert an den Ausgängen 218 des Addierers 211 verändert sich nicht mehr. Nach Zurücknehmen des Steuerbefehls "Betriebsart assoziativ" durch den Rechner wird die Schaltungsanordnung vollends angehalten.

Es bleibt noch zu erwähnen, daß bei allen Schaltungsvarianten der Assoziativbetrieb jederzeit durch Zurücknahme des Steuerbefehls "Betriebsart assoziativ" unterbrochen und nach dessen Wiedereinschalten bei der letzten untersuchten Adresse wieder fortgesetzt werden kann. Damit ist jederzeit ein direkter Speicherzugriff (DMA) von außen möglich. Es ist auch möglich, mit der Schaltungsanordnung nach Fig. 1 das simultane Abarbeiten mehrerer Programme zuzulassen, da während der Abarbeitung eines Befehls des einen Programms der Speicher der Datenverarbeitungsanlage (hier Speicher 10) im Assoziativbetrieb für ein anderes Programm betrieben werden kann.

## Patentansprüche

1. Verfahren zum assoziativen Betrieb eines direktadressierbaren Speichers (10) unter Verwendung eines Suchwortregisters (22), dessen Inhalt bei einem Suchvorgang mit einem jeweils ausgelesenen Speicherwort verglichen wird, um bei Übereinstimmung ein Treffersignal zu erzeugen, wobei nach dem Laden des Suchwortes in das Suchwortregister (22) eine frei wählbare Startadresse für den Suchvorgang bereitgestellt wird, ein vorbestimmten Schrittweiten zwischen anzusteuernden Speicherworten entsprechender, in seiner Größe frei wählbarer Summand bereitgestellt wird, und die Speicheradressen durch fortlaufendes Aufaddieren des Summanden bis zum Erreichen der höchst möglichen Adresse erzeugt werden.

2. Verfahren nach Anspruch 1, dadurch **gekennzeichnet**, daß die Adreßwerte innerhalb eines vorbestimmten Adreßvolumens erzeugt werden, bei dessen höchstwertigem Endadreßwert die Adreßwerterzeugung unterbrochen wird.

3. Verfahren nach Anspruch 1 oder 2, dadurch **gekennzeichnet**, daß die Adreßwerterzeugung bei Erreichen eines den inhaltsgesteuerten Speicherzugriff veranlassenden Adreßwertes oder des Endadreßwertes durch Addition des Summanden 0 zum jeweils erreichten Adreßwert unterbrochen wird.

4. Verfahren nach einem der Ansprüche 1 bis 3, dadurch **gekennzeichnet**, daß die Adreßwerterzeugung durch die Rückflanken eines für den Speicherzugriff verwendeten Lesetaktsignals gesteuert wird.

5. Schaltungsanordnung zur Durchführung des Verfahrens nach Anspruch 1 oder 2, die einen die Adreßwerte abgebenden Addierer (211) aufweist dessen erste Summandeneingänge (210) mit einem Startadreßregister (201) und dessen zweite Summandeneingänge (212) mit einem Summandenregister (203) verbindbar sind, in die der Anfangsadreßwert und der jeweilige Summand von einer den Speicher enthaltenden Datenverarbeitungsanlage eingebbar sind, wobei die ersten Summandeneingänge (210) auf die Ausgänge (221) eines mit dem jeweils abgegebenen Adreßwert angesteuerten Summenregisters (220) umschaltbar sind, dessen Ladesteuereingang durch das Lesetaktsignal angesteuert ist, die Ausgänge des Addierers mit den Adreßeingängen des Speichers verbindbar sind, und eine Vergleichsvorrichtung mit den Ausgängen des Suchwortregisters und des Speichers verbunden ist.

6. Schaltungsanordnung nach Anspruch 5, zur Durchführung des Verfahrens nach Anspruch 3, dadurch **gekennzeichnet**, daß den ersten und den zweiten Summandeneingängen (210, 212) jeweils ein Multiplexumschalter (208, 214) vorgeschaltet ist, der von dem Startadreßregister (201) bzw. dem Summandenregister (203) angesteuert ist, und daß eine Eingangsgruppe (217) des von dem Summandenregister (203) angesteuerten Multiplexumschalters (214) mit Nullpotential beschaltet ist.

7. Schaltungsanordnung nach Anspruch 6 oder 7, dadurch **gekennzeichnet**, daß nur das Summenregister (220) durch das für den Speicherzugriff verwendete Lesetaktsignal angesteuert ist.

## Claims

1. Method for the associative operation of a directly addressable memory (10) using a search word register (22), whose contents are compared with a read out memory word in a search process, in order to produce a success signal when these correspond, whereby, after loading the search word in the search word register (22), a freely selectable start address for the search process is provided, an addend, the value of which is freely selectable, is provided corresponding to predetermined pitches between memory words to be accessed, and the memory addresses are generated by progressive adding up of the addend until the highest possible address is reached.

2. A method according to claim 1 **characterised** in that the address values are generated within a predetermined address range with the address value generation being interrupted at the highest valued end address value.

3. A method according to claim 1 or 2 **characterised** in that upon reaching an address value effecting the content controlled memory access or upon reading the end address value the address value generation is interrupted by the addition of the addend 0 to the respectively reached address value.

4. A method according to one of claims 1 to 3 **characterised** in that the address value generation is controlled by the rear edges of a read clock signal used for the memory access.

5. A circuit arrangement for carrying out the method of claim 1 or 2 comprising an address value generating adder (211) whose first addend inputs (210) are connectable with a start address register (201) and whose second addend inputs (212) are connectable with an addend register (203), into which start address register and addend register the start address value and the respective addend are loadable from a data processing system containing the memory, whereby the first addend inputs (210) are switchable to the outputs (221) of a sum register (220) fed by the respective furnished address value whose load control input is controlled by the read clock signal, the outputs of the adder are connectable with the memory's address inputs and a comparator device is connected with the outputs of the search word register and of the memory.

6. A circuit arrangement according to claim 5 for carrying out the method according to claim 3, **characterised** in that the first and second addend inputs (210, 212) are connected to a multiplexer (208, 214) which is fed by the start address register (201) or the addend register (203), and that one input group (217) of the multiplexer (214) fed by the addend register (203) is connected to zero potential.

7. A circuit arrangement according to claim 6 or 7 **characterised** in that only the sum register (220) is controlled by the read clock signal used for memory access.

## Revendications

1. Procédé pour le fonctionnement associatif d'une mémoire (10) à adressage direct, par utilisation d'un registre de mots clés (22), dont le contenu est comparé au cours d'une recherche à un mot sélectionné dans une mémoire, afin d'engendrer, en cas de concordance, un signal de cible, dans lequel, après chargement du mot clé dans le registre de mots clés (22), une adresse de lancement, à sélectionner librement, est préparée pour la recherche, dans lequel un opérande de somme, de valeur librement sélectionnable, correspondant à des pas déterminés entre des mots de mémoire à commander, est préparé, et dans lequel les adresses de mémoire sont produites par addition continue de l'opérande jusqu'à obtention de la plus grande adresse possible.

2. Procédé selon la revendication 1, caractérisé en ce que les valeurs d'adresse sont produites à l'intérieur d'un volume d'adresses prédéterminé, la production de valeurs d'adresse étant interrompue pour sa plus haute valeur d'adresse finale.

3. Procédé selon la revendication 1 ou 2, caractérisé en ce que la production de valeurs d'adresse est interrompue lorsqu'est atteinte une valeur d'adresse entraînant l'accès à la mémoire commandée par le contenu, ou la valeur d'adresse finale, en ajoutant l'opérande 0 à la valeur d'adresse obtenue chaque fois.

4. Procédé selon l'une des revendications 1 à 3, caractérisé en ce que la production de valeurs d'adresse est commandée par les flancs arrière d'un signal de synchronisation de lecture utilisé pour l'accès à la mémoire.

5. Circuit pour la mise en oeuvre du procédé selon la revendication 1 ou 2, qui comporte un totalisateur (211) délivrant les valeurs d'adresse, dont les premières entrées d'opérande (210) peuvent être reliées à un registre d'adresses de lancement (201) et dont les deuxièmes entrées d'opérande (212) peuvent être reliées à un registre d'opérandes (203), circuit dans lequel la valeur d'adresse initiale et l'opérande correspondant peuvent être introduits par un système informatique contenant la mémoire, caractérisé en ce que les premières entrées d'opérande (210) peuvent être commutées sur les sorties (221) d'un registre de sommes (220) commandé par la valeur d'adresse délivrée dans chaque cas, dont l'entrée de commande de charge est commandée par le signal de synchronisation de lecture, les sorties du totalisateur peuvent être reliées aux entrées d'adresse de la mémoire et un dispositif de comparaison est relié aux sorties du registre de mots clés et de la mémoire.

6. Circuit selon la revendication 5 pour la mise en oeuvre du procédé selon la revendication 3, caractérisé en ce qu'il est monté en avant des premières entrées d'opérande (210) et en avant des deuxièmes entrées d'opérande (212), un commutateur multiplex (208, 214) qui est commandé respectivement par le registre d'adresses de lancement (201) ou par le registre d'opérandes (203), et en ce qu'un groupe d'entrée (217) du commutateur multiplex (214) commandé par le registre d'opérandes (203) est relié au potentiel zéro.

7. Circuit selon la revendication 6 ou 7, caractérisé en ce que seul le registre de sommes (220) est commandé par le signal de synchronisation de lecture utilisé pour l'accès à la mémoire.

Fig. 1

LESETAKT → 103 CLCK 100

LADEN
STARTADRESSE → 102 LOAD 104 ADR 38

START → 105 106
STOP → 108 109
BETRIEBSART
ASSOZIATIV → 107 110 ENABLE ÜBERLAUF 111

23 → 101

Fig. 2

START → 232 230
STOP → 233
BETRIEBSART
ASSOZIATIV → 234 231

LADEN
SUMMAND → 205 203 SUMMAND REG. 217 229 214 212 211 ÜBERLAUF 235 218

MUX 213

216 215

START → 202
LADEN
START-ADR → 204 START ADR. REG. 206 207 228 MUX 209 ADDIERER ADR 38

23 → 200 201 222 208 210 223 220

LESETAKT → 227 225
BETRIEBSART
ASSOZIATIV → 226 224 221 M REG. 219

Fig. 3